(19) Europäisches Patentamt
European Patent Office
Office européen des brevets

(11) **EP 0 616 558 B1**

# (12) EUROPÄISCHE PATENTSCHRIFT

(45) Veröffentlichungstag und Bekanntmachung des Hinweises auf die Patenterteilung:
**05.11.1997 Patentblatt 1997/45**

(21) Anmeldenummer: **92919431.4**

(22) Anmeldetag: **11.09.1992**

(51) Int. Cl.⁶: **B05D 7/00**, C25D 5/54, C23C 18/18

(86) Internationale Anmeldenummer:
**PCT/DE92/00788**

(87) Internationale Veröffentlichungsnummer:
**WO 93/11881 (24.06.1993 Gazette 1993/15)**

(54) **VERFAHREN ZUR BESCHICHTUNG VON OBERFLÄCHEN MIT FEINTEILIGEN FESTSTOFF-PARTIKELN**

METHOD OF COATING SURFACES WITH FINELY PARTICULATE MATERIALS

PROCEDE POUR RECOUVRIR DES SURFACES DE PARTICULES DE MATIERES SOLIDES

(84) Benannte Vertragsstaaten:
**AT DE FR GB IT NL SE**

(30) Priorität: **11.12.1991 DE 4141416**

(43) Veröffentlichungstag der Anmeldung:
**28.09.1994 Patentblatt 1994/39**

(73) Patentinhaber: **ATOTECH Deutschland GmbH
10553 Berlin (DE)**

(72) Erfinder:
• **BESENHARD, Jürgen, Otto
D-4435 Horstmar (DE)**
• **CLAUSSEN, Olaf
D-4400 Münster (DE)**
• **GAUSMANN, Hans-Peter
D-4400 Münster (DE)**

• **MEYER, Heinrich
D-1000 Berlin 39 (DE)**

(74) Vertreter: **Effert, Udo, Dipl.-Ing.
Patentanwalt
Radickestrasse 48
12489 Berlin (DE)**

(56) Entgegenhaltungen:
**EP-A- 0 139 233          EP-A- 0 200 398
EP-A- 0 398 019          WO-A-92/19092
US-A- 4 634 619          US-A- 4 874 477**

• **Römpps Chemie-Lexikon, 8. Auflage, Seiten 1317-1318**

Bemerkungen:
Die Akte enthält technische Angaben, die nach dem Eingang der Anmeldung eingereicht wurden und die nicht in dieser Patentschrift enthalten sind.

**Beschreibung**

Die Erfindung betrifft ein Verfahren zur Beschichtung von Oberflächen aller Art, vorzugsweise von elektronisch nicht-leitenden Oberflächen, mit hochdispersen Feststoff-Teilchen aller Art, vorzugsweise mit elektronisch leitenden Feststoff-Teilchen, durch Eintauchen der zu beschichtenden Körper in (a) eine wäßrige Lösung von Polymeren und anschließend in (b) eine mit Tensiden stabilisierte elektrolythaltige Dispersion der Feststoff-Teilchen.

Gegenstand der Erfindung ist also ein Verfahren zur Belegung von Oberflächen aller Art mit hochdispersen Feststoff-Teilchen aller Art. Ein besonderes Merkmal des Verfahrens besteht darin, daß es mit äußerst geringen Mengen an Bindemitteln auskommt und somit Funktionen und Eigenschaften der hochdispersen Feststoff-Teilchen, wie z. B. deren katalytische Aktivität oder elektrische Leitfähigkeit, wenig beeinträchtigt. Außerdem werden im Rahmen des erfindungsgemäßen Verfahrens nur niederviskose Dispersionen von Feststoff-Teilchen angewendet, so daß auch sehr feine Strukturen und Poren mit konstanter Schichtdicke, d.h. "konturenscharf" belegt werden können, ohne zu "verkleben".

Das Beschichten von Oberflächen durch "Tauchlackierung" mit "Dispersionsfarben" ist ebenfalls ein weitverbreitetes Verfahren, das in der Technik vor allem zur Beschichtung von Metallen genutzt wird, aber prinzipiell zur Beschichtung praktisch aller Werkstoffe geeignet ist. Gemeinsame Merkmale typischer Dispersionsfarben sind Lösungs- bzw. Verdünnungsmittel, in denen feste, feinteilige Pigmente meist unter Zusatz von Hilfsmitteln, die das Sedimentieren verhindern sollen, verteilt sind und Bindemittel, die nach Verdunsten der Lösungsmittel, häufig auch noch durch zusätzliche Einwirkung von Luft oder erhöhter Temperatur, eine auf der zu beschichtenden Oberfläche haftende und die Pigmente fest einschließende Matrix erzeugen. Selbstverständlich können solche Dispersionsfarben auch durch andere Methoden als das Tauchen, also z.B durch Aufsprühen oder Streichen, aufgebracht werden.

Darüberhinaus muß die Viskosität gängiger Dispersionsfarben insbesondere für die Tauchlackierung und für das Streichen glatter Oberflächen relativ hoch "eingestellt" werden, um nach dem Beschichtungsschritt einen Film ausreichender Dicke, somit mit ausreichender Pigmentmenge, zu erhalten. Als Nachteil muß dabei hingenommen werden, daß feingliedrige Strukturen nicht erzeugt werden können oder Poren "verkiebt" werden bzw. hohe Auflösungen bei der Bedeckung feiner Strukturen nicht möglich sind.

Innerhalb der Japanischen Patentschrift 63 317 096 werden Kohlenstoff-Pasten zum Aufbringen dünner elektrisch leitender Schichten auf Isolatoren beschrieben Die Pasten enthalten feinteilige Kohlenstoffe. In der Japanischen Patentschrift 61 202 890 werden ähnliche Pasten zum Aufbringen von Wärmeableitern auf Leiterplatten beschrieben. Die Pasten enthalten z.B. Graphitpulver und Bindemittel, wie Acrylharze oder Ethylcellulose. Ähnliche Pasten, hergestellt unter Verwendung von Kohlenstoff und Gelatine oder Leim beschreibt auch die Japanische Patentschrift 62 241 929.

"Leitfähige Farben" mit Kohlenstoff und Bindemitteln wurden auch schon viel früher erwähnt. Beispiele hierfür sind etwa "aufstreichbare Heizelemente, anzubringen an Wänden von Gebäuden" (US-PS 4 035 265), wobei Graphit bzw. Ruß in Kombination mit lufthärtenden Bindern zur Verwendung kommt. Leitende Beschichtungen von Glasfasern mit einer Dispersion von Ruß in Polyacrylat-Emulsionen werden in US-PS 4 090 984 beschrieben. Zur leitenden Beschichtung von Geweben sind Dispersionen von Ruß in Lösungen, die Latex als Binder enthalten, beschrieben; US-PS 4 239 794.

Wenn bei der Beschichtung mit Dispersionen von leitenden Partikeln feine Strukturen und insbesondere Poren erhalten bleiben sollen, muß die Viskosität der Dispersionen und ihr Pigmentgehalt herabgesetzt werden. Damit wird aber die Schichtdicke des durch Tauchen oder Streichen aufbringbaren Films entsprechend geringer, wobei die damit verbundene geringere Belegung der Oberfläche mit leitenden Partikeln oft zu drastisch verringerten Oberflächenleitfähigkeiten führt. Eine nachfolgende galvanische Metallisierung ist dann nur noch bedingt möglich, da galvanische Metallabscheidungen bei geringer Oberflächenleitfähigkeit nur noch in unmittelbarer Nähe der Stromzuführung einsetzen und erst nach längerer Zeit, aufgrund der dann durch die Metallabscheidung bewirkten Leitfähigkeitssteigerung, weiter vorwärts "kriechen".

Beschichtungen von Nichtleitern durch Tauchen in niederviskose Dispersionen leitender Kohlenstoff-Materialien können allerdings in bestimmten Fällen eine für galvanische Metallabscheidungen ausreichende und auch technisch nutzbare Oberflächenleitfähigkeit bewirken. Das trifft insbesondere für das galvanische Metallisieren von Bohrlöchern in kupferkaschierten Leiterplatten zu, da es für diese Anwendung genügt, wenn eine galvanische Metallabscheidung in unmittelbarer Nähe, typischerweise in einem Umkreis von ca. 2 mm, um die als Stromzuführung benutzte Kupferkaschierung noch erfolgt.

Allerdings haben solche noch ausreichende Oberflächenleitfähigkeiten nicht nur den Nachteil, daß eine galvanische Metallabscheidung in größerer Entfernung vom Kontakt nicht, bzw. erst nach längerer Abscheidungsdauer, möglich ist. Wenn galvanische Abscheidungen nicht von Anfang an "vollflächig" erfolgen, entstehen zwangsläufig Abscheidungen sehr ungleichmäßiger Dicke, wie z.B. "Keilprofile" mit maximaler, und in der Regel unnötiger und unerwünschter, Dicke des Keils an der Kontaktstelle.

Die Erhöhung der Oberflächenleitfähigkeit ist also auch dann ein erstrebenswertes und wirtschaftlich wichtiges Ziel, wenn schon mit weitaus geringeren Oberflächenleitfähigkeiten eine Galvanisierung grundsätzlich möglich ist, denn sie spart Zeit und Material bei verbesserter Qualität der galvanischen Abscheidungen.

Speziell zur Galvanisierung von Bohrlöchern kupferkaschierter Leiterplatten sind eine Reihe von eng verwandten Verfahren bekanntgeworden (beschrieben z.B. in US-PS 4 619 741, US-PS 4 622 108, US-PS 4 631 117 und US-PS 4 684 560), deren gemeinsames Merkmal es ist, daß die isolierenden Innenwände der Bohrlöcher (in der Regel bestehen die Leiterplatten aus Glasfaser-Epoxy-Verbundwerkstoffen) durch Tauchen in Lösungen, die feinteiligen dispergierten Kohlenstoff enthalten, mit diesem Kohlenstoff in sehr dünner Schicht belegt werden. In einem Folgeschritt wird die Kohlenstoff-Belegung durch Trocknung bei erhöhter Temperatur fixiert, wodurch eine als Grundlage für die nachfolgende galvanische Verkupferung der Bohrlöcher ausreichend leitende Schicht entsteht.

Allen oben genannten Verfahren zur Bohrlochmetallisierung von Leiterplatten ist auch gemeinsam, daß die Dispergierung des Kohlenstoffs durch die Anwendung von Tensiden erfolgt. Eine Vorbehandlung der mit Kohlenstoff zu belegenden Substrate erfolgt nach der Lehre der Patentschriften US-PS 4 619 741, US-PS 4 631 117 und US-PS 4 684 560 durch eine wäßrige Reinigungs- und Konditionierlösung, deren wesentliche Bestandteile Ethylenglykol und Monoethanolamin sind. In der Patentschrift US-PS 4 622 108 wird eine Reinigungs- und Konditionierlösung beschrieben, die neben Ethylenglykol und Monoethanolamin auch noch ein nichtionisches Netzmittel enthält.

Die physikalisch-chemischen Grundlagen, die die Haftung der Kohlenstoff-Partikel auf der Kunststoffoberfläche bewirken, sind in den oben genannten U.S. Patentschriften nicht erläutert. Insbesondere sind keine Erkenntnisse offengelegt, in welcher Weise die Reinigungs- bzw. Konditionierlösung den Haftungsvorgang beeinflussen könnte. Es wird vielmehr mehrfach darauf hingewiesen, daß nach der Anwendung der Reinigungs- bzw. Konditionierlösung die Leiterplatten gründlich zur Entfernung von Resten dieser Lösungen gespült werden müssen (siehe US-PS 4 684 560 Spalte 5, Zeile 64/65 und US-PS 4 619 741 Spalte 5, Zeile 47/48).

In der weiter unten folgenden Beschreibung dieser Erfindung wird dagegen dargelegt, welche Schlüsselfunktion gezielt auf die Feststoff-Dispersion abgestimmte Vortauchlösungen für das Erreichen einer guten Belegung der Substrat-Oberfläche mit Feststoff-Partikeln haben.

Auch spezifisch wirksame Vortauchlösungen, mit Bestandteilen, die eine bessere Haftung von Feststoff-Partikeln auf Substratoberflächen bewirken, sind schon beschrieben worden. So hat z.B. M.A. Hubbe (Colloids Surf., 25 (1987) 325) beschrieben, daß durch Vorbehandlung von Cellulose oder Glas mit kationischen Polyelektrolyten die Adhäsionskräfte zwischen Titanoxidhydraten und Cellulose bzw. Glas um den Faktor 30 gesteigert werden. Ähnliches wird von S. Varennes und T.G.M. Van de Ven (Colloids Surf., 33 (1988) 63) über die Verstärkung der Haftung von Latex-Kügelchen auf Glas, das mit kationischen Polyelektrolyten ("catfloc") vorbehandelt wurde, berichtet. Varennes und Van de Ven deuten ihre Befunde als Wechselwirkung zwischen entgegengesetzten Ladungen.

Auch für die Belegung von Leiterplatten mit Kohlenstoff-Teilchen ist das Prinzip der Vorbehandlung der Substrate mit kationischen Polyelektrolyten schon benutzt worden (US-PS 4 874 477).

Unbefriedigend gelöst ist bisher die Güte der Haftung der Kohlenstoff-Partikel auf der Nichtleiteroberfläche.

Weitere Verfahren zum direkten elektrolytischen Beschichten von Durchgangslöchern in einem metallkaschierten dielektrischen Laminat mittels Feststoffpartikeln sind in den Druckschriften EP 0398 019 B1 und WO92/19092 A1 offenbart:

In EP 0398 019 B1 wird zur Fixierung von elektronenleitenden Feststoffpartikeln auf den Substratoberflächen zunächst ein Tensid auf die Oberfläche aufgebracht und anschließend die Feststoffpartikel aus einer Graphitpulver und mittels Zinn-(II)-hydroxid stabilisierten Palladium-Kolloid enthaltenden Dispersion.

Das in WO92/19092 A1 angegebene Verfahren schließt neben einem Vorbehandlungsschritt mittels einer Gelatine- oder Polyacrylat-Lösung und dem anschließenden Verfahrensschritt zur Beschichtung mit Kohlenstoff mittels einer neben Kohlenstoff zusätzlich Netzmittel und eine ionogene Metallverbindung enthaltenden Dispersion zusätzliche Verfahrensschritte mit einer kupferhaltigen Lösung, beispielsweise einer Kupfer-(I)-halogenid enthaltenden Lösung, ein.

Der vorliegenden Erfindung liegt von daher das Problem zugrunde, ein Verfahren bereitzustellen, mit dem die Haftung bestimmter Feststoff-Partikel auf einer Nichtleiteroberfläche, insbesondere auf den Innenwänden von Bohrungen in Leiterplatten, erhöht wird und eine Beschichtung mit Feststoffpartikeln selektiv nur dort erreicht wird, wo die zu beschichtende Oberfläche mit einer ersten Komponente belegt ist, die mit einem die Feststoffpartikel enthaltenden zweiten Mittel zur Erzielung des Beschichtungseffektes wechselwirkt.

Gelöst wird dieses Problem gemäß der Lehre des Patentanspruches 1. Weiterbildungen der Erfindung sind in den Unteransprüchen aufgeführt.

Zentraler Punkt der vorliegenden Erfindung ist ein Prozeß, der nicht nur zur Adsorption dispergierter Teilchen an Substratoberflächen, sondern zur lokalen Koagulation ausschließlich an der Substratoberfläche führt. Die Substratoberfläche muß dazu mit einem die Koagulation auslösenden Stoff belegt sein. Mit dieser substratinduzierten lokalen Koagulation können im Vergleich zur einfachen Adsorption sehr viel größere Mengen der Partikel gezielt an der Oberfläche abgeschieden werden.

Das Gelingen einer derartigen substratinduzierten lokalen Koagulation, die natürlich nicht in das Volumen der Dispersion fortschreiten darf, erfordert eine Reine von Maßnahmen, die zunächst allgemein beschrieben werden sollen.

Ein wesentlicher Punkt für das Gelingen des Prozesses ist die Abstimmung der beiden Komponenten a) Koagulationsauslöser auf dem Substrat und b) koagulationsfähige Dispersion. Es handelt sich also um ein "2-Komponenten-Verfahren", bestehend aus 2 Lösungen, Vortauchlösung und einer darauf abgestimmten Dispersion der Feststoff-Partikel in einer niederviskosen Flüssigkeit.

Die Auslegung dieser Dispersion muß anders gestaltet sein als die herkömmlicher Dispersionen, in denen man durch reichliche Anwendung von Stabilsatoren die normalerweise unerwünschte und häufig irreversible Koagulation nach Möglichkeit verhindert. Die erfindungsgemäßen Dispersionen sind "knapp" stabilisiert und vor allem durch dosierten Zusatz ausgewählter Elektrolyte ausreichend nahe an den Koagulationspunkt gebracht.

Eine sparsame Verwendung der stabilisierenden Tenside, die zur Erzielung guter Ergebnisse vorzugsweise anionisch oder kationisch geladen sein sollten, ist aber in der Regel nicht ausreichend, um Dispersionen aufzubauen, die dann in Kontakt mit einem geeigneten destabilisierenden Stoff spontan koagulieren. In dem erfindungsgemäßen Verfahren wird daher eine Dispersion durch Zusätze gezielt so weit destabilisiert, daß unter den Verfahrensbedingungen eine Koagulation an der Phasengrenze erfolgt.

Die Wahl der tensidischen Stabilisatoren, die das Ausflocken der Feststoff-Teilchen verhindern sollen, ist für das Funktionieren der substratinduzierten Koagulation nicht besonders kritisch. Nahezu alle bekannten Typen von Stabilisatoren sind im Prinzip geeignet, so daß z.B. auf die Verträglichkeiten mit den zu stabilisierenden Feststoff-Teilchen Rücksicht genommen werden kann.

Desgleichen stehen auch bei der Wahl des zur partiellen Destabilisierung der Dispersionen zuzusetzenden Salze (Elektrolyte) vielfältige Auswahlmöglichkeiten offen. Gute Ergebnisse wurden mit Fluoriden, Chloriden, Bromiden oder Jodiden des Lithiums, Natriums, Kaliums, Magnesiums, Calciums, Bariums, Strontiums, Ammoniums oder Kupfers erzielt; aber auch Nitrate oder Sulfate sind geeignet.

Typische Konzentrationen der Elektrolytzusätze liegen um 0,05 Mol/l, wobei jedoch je nach verwendetem Stabilisator auch wesentlich höhere oder niedrigere Konzentrationen zweckmäßig sein können.

Ein gut geeignetes Lösungsmittel für diese Dispersionen ist Wasser, allerdings können, z.B. bei Benetzungsschwierigkeiten auf der Substratseite, als Zusatz zu Wasser oder auch ausschließlich andere polare Lösungsmittel, z.B. Alkohole oder Ketone, eingesetzt werden.

Die Auswahl der feinteiligen Feststoffe, die nach dem Prinzip der substratinduzierten Koagulation auf Oberflächen niedergeschlagen werden können, ist nicht beschränkt. Neben verschiedenen Kohlenstoff-Materialien lassen sich beispielsweise auch feinteilige Oxide wie Kieselsäure ($SiO_2$), Wolframblau ($H_xWO_3$), oder Schichtverbindungen wie $MoS_2$ substratinduziert koagulieren.

Um eine Koagulation ausschließlich oder überwiegend im Volumen der Dispersion, und damit ihre Zerstörung, zu vermeiden, muß der die Koagulation auslösende Stoff an der Substratoberfläche haften bleiben. Dies kann insbesondere durch polymere Koagulationsauslöser erfolgen, die von der Oberfläche zumindest nur sehr langsam abgelöst werden können, wodurch ein möglicher Ablöseprozess von der einsetzenden Koagulation "überholt" wird. Außerdem bedecken solche Makromoleküle in der Regel weitaus weniger Oberfläche, als man es aufgrund ihrer Abmessungen erwarten würde. Vielmehr ragen oft erhebliche Anteile der Moleküle in Form von "Schleifen" oder "Tentakeln" ins Lösungsinnere, wodurch eine gegenüber kleinen Molekülen mit ansonsten ähnlichen Eigenschaften drastisch erhöhte "Reichweite" ihrer Wirksamkeit bedingt ist.

Als geeignet für eine koagulationsauslösende Vorbehandlung von Substraten für eine substratinduzierte Koagulation hat sich eine große Zahl von wasserlöslichen Polymeren erwiesen, wobei offensichtlich das Vorhandensein oder das Vorzeichen einer Ladung keine besondere Rolle spielt. Gute Ergebnisse wurden mit Gelatine erzielt, ebenso mit Polyacrylaten, die zur Verbesserung ihrer Löslichkeit eine gewisse Anzahl von Ammoniumgruppen tragen können (z.B. Basoplast-Typen der BASF). Geeignet sind auch andere wasserlösliche Peptide wie z.B. die Albumine.

Neben den genannten, in der Regel eine geringe kationische Ladungsdichte tragenden, hochmolekularen Stoffen sind auch noch zahlreiche weitere kationisch geladene Polyelektrolyte als Koagulationsauslöser sehr gut geeignet, z.B. Copolymerisate des Acrylamids oder Methacrylamids mit Salzen oder Quarternisierungsprodukten von Aminoacrylaten oder andere Polyelektrolyte, die einfache oder substituierte Ammoniumgruppen tragen. Zahlreiche Verbindungen dieser Art sind als "Flockungsmittel" im Handel und tragen Bezeichnungen wie z.B. Superfloc (American Cyanamid), Etadurin (Akzo), Sedipur (BASF), Magnafloc (Allied Colloids), Nalcolyte (Nalco), Sanfloc (Sanyo) oder Separan (Dow Chemical).

Es wurde überraschend gefunden, daß sich dabei die kationischen Polyelektrolyte mit relativ geringer Ladungsdichte (< 0,5 meq/g) als bessere Koagulationsauslöser erweisen als die mit höherer Ladungsdichte. Dies ist ein Hinweis dafür, daß nicht einfache elektrostatische Wechselwirkungen zwischen der "kationischen Oberfläche" und anionisch stabilisierten Feststoff-Partikeln für deren Haftung verantwortlich sind.

Es ist aber keinesfalls so, daß nur kationisch geladene hochmolekulare Stoffe als Koagulationsauslöser geeignet sind. Mit einer Reihe von ungeladenen wasserlöslichen Makromolekülen, so z.B. mit Polyacrylamiden, mit Polyvinylpyrrolidonen oder mit Polyvinylalkoholen (z.B. Mowiol-Typen der Fa. Hoechst) nicht zu geringer durchschnittlicher Molmasse (vorzugsweise > 10 000 U) lassen sich Ergebnisse erhalten, die mit denen von kationischen Polyelektrolyten vergleichbar sind. Andere geeignete ungeladene Makromoleküle sind z.B. Polyethylenglykole und Polyethylenglykolether, Epichlorhydrin-Imidazol-Addukte, Polyvinylimidazole, Polysaccharide wie Agar-Agar, Stärke, Pektine oder Dextrane und Zuckerpolymere, wie z.B. Alginsäuren.

Schließlich kann auch mit anionisch geladenen hochmolekularen Stoffen eine koagulationsauslösende Wirkung erzielt werden. Beispiele hierfür sind das Na-Salz der Carboxymethylcellulose oder das Na-Salz der "Alginsäure", einem Mischpolymerisat der Mannuron- und Glucuronsäure. Andere geeignete anionisch geladene hochmolekulare Stoffe sind beispielsweise Alkalisalze der Polycarbonsäuren wie z.B. der Polyacrylsäure oder der Polyvinylphosphorsäure.

Ein Beweis dafür, daß der der Erfindung zugrunde liegende Effekt nicht in einfacher Weise auf der elektrostatischen Anziehung entgegengesetzter Teilchen beruht, ist die Tatsache, daß z.B. mit kationischen Koagulationsauslösern wie Gelatine bei einem pH- Wert um 3,2 in Kombination mit ebenfalls kationisch stabilisierten Feststoff-Partikeln (vergl. Ausführungsbeispiele 3 und 10) eine Koagulation herbeigeführt werden kann.

In ganz ähnlicher Weise können mit anionischen Koagulationsauslösern wie Alginat oder Carboxymethylcellulose-Na-Salz auch anionisch stabilisierte Feststoff-Partikel an Substraten koaguliert werden (vergl. Ausführungsbeispiele 2 und 5).

Bei dieser Sachlage ist es auch nicht mehr erstaunlich, daß mit ladungsneutralen Koagulationsauslösern ebenfalls anionisch und kationisch stabilisierte Feststoff-Partikel an Substraten koaguliert werden können (vergl. Ausführungsbeispiele 4, 7, 8, 9, 11 und 14).

Durch substratinduzierte Koagulation von Feststoff-Partikeln beschichtbare Substratmaterialien:

Das Verfahren der substratinduzierten Koagulation ist demnach im Hinblick auf die Eigenschaften des zu beschichtenden Materials wenig differenzierend, d.h., es können mit dem erfindungsgemäßen Verfahren praktisch alle Materialien auf diese Weise beschichtet werden. Tatsächlich spielt das Material des Substrates nur eingeschränkt eine Rolle beim Koagulationsvorgang. Die einzige Voraussetzung, die für das Gelingen des Vorgangs erfüllt sein muß, ist eine ausreichende Belegung der Substratoberfläche mit einem Koagulationsauslöser.

Diese Voraussetzung kann mit wasserlöslichen Polymeren auf praktisch allen Substraten erfüllt werden. Selbst das hydrophobe wie lipophobe PTFE (Teflon) behält nach dem Tauchen in wäßrige Lösungen des Koagulationsauslösers Gelatine, selbst nach anschließender Spülung mit Wasser, noch genügende Mengen des koagulationsauslösenden Stoffes an seiner Oberfläche, so daß es sich beim Eintauchen in erfindungsgemäße Ruß-Dispersionen mit einer dichten Ruß-Schicht überzieht.

Andere Kunststoffe, etwa die polaren Epoxide, Polyamide, Polyimide, Phenolharze, ABS-Kunststoff oder die unpolaren, wie Polyethylen und Polypropylen lassen sich ebenso wie Metalle oder Glas mit Feststoff-Partikeln belegen.

Sofern eine regioselektive Belegung gewünscht wird, kann dies durch entsprechende Masken schon beim Tauchen in die Polymerlösung erreicht werden. Bereiche, die hier abgedeckt waren, werden beim zweiten Tauchschritt nicht von koagulierten Partikeln bedeckt. In bestimmten Fällen ist es auch möglich, substratselektive Belegungen zu erreichen. Wegen der geringen Substratspezifität des Koagulationsprozesses ist dies allerdings nur durch Nachbehandlungen realisierbar.

Es ist überraschend und bemerkenswert, daß der Mechanismus der dieser Erfindung zugrundeliegenden substratinduzierten Koagulation nicht in trivialer Weise als Wechselwirkung zwischen entgegengesetzten Ladungen auf der Substratoberfläche (bewirkt z.B. durch ein positive Ladungen tragendes adsorbiertes Polymer) und auf den Feststoff-Partikeln (bewirkt z. B. durch ein negative Ladungen tragendes anionisches Tensid) aufzufassen ist.

Die Ausführungsbeispiele belegen, daß überraschenderweise eine substratinduzierte Koagulation auch dann erfolgen kann, wenn die Substratoberfläche und die suspendierten Partikel gleichsinnig geladen oder auch praktisch ungeladen sind. Tatsächlich konnte mit nahezu allen Kombinationen von Substratbelegungen (kationische, anionische und neutrale Polymere) und Stabilisatoren für die suspendierten Teilchen (kationische, anionische und ambivalente Tenside) der Effekt der substratinduzierten Koagulation deutlich beobachtet werden, wenn auch mit unterschiedlich guten Ergebnissen. Insbesondere zur Stabilisierung der Feststoff-Dispersionen haben sich geladene Tenside besser bewährt als ungeladene.

Die geringe Bedeutung der Ladung der auf den Substraten adsorbierten Polymeren wird auch dadurch belegt, daß bei einer Kombination von kationischen Polymeren (Polyelektrolyte auf der Basis von Acrylamid) auf der Substratoberfläche (Epoxid) und anionisch (Aerosol OT, Cyanamid) stabilisierten Ruß-Dispersionen (Furnaceruß Printex L 6, Degussa) höhere Rußbelegungen mit abnehmender Ladungsdichte der kationischen Polymeren gefunden werden.

Ein entscheidender Vorteil hochmolekularer Koagulationsauslöser im Vergleich zu niedermolekularen ist die bessere Haftung auf der Substratoberfläche, die schon rein statistisch durch die große Anzahl möglicher Koordinationsstellen gegeben ist. Außerdem ragen hochmolekulare an Oberflächen adsorbierte Substanzen mit "Schleifen" und "Tentakeln" weit in die Lösung hinein, so daß ihre Wirkung nicht nur auf die unmittelbare Oberfläche beschränkt ist.

Ein wesentlicher Bestandteil der für eine substratinduzierte Koagulation geeigneten "knapp" stabilisierten Dispersionen ist ihr Elektrolytgehalt. Mit zunehmendem Elektrolytgehalt nimmt bekanntlich die Stabilität von kolloiden Dispersionen ab, bis schließlich eine kritische Koagulationskonzentration erreicht wird (vergl. z.B. J. Gregory, Material Science Forum, 25/26 (1988) 125). Die für die "knappe" Einstellung der Dispersionen geeigneten Elektrolytkonzentrationen müssen experimentell ermittelt werden, wobei die Wahl der Elektrolyte nicht besonders kritisch ist. Wichtig ist, daß die Dispersion einerseits nahe genug an die Flockungsgrenze herangebracht wird, wobei andererseits eine hinreichende Stabilität noch gewährleistet sein muß.

Besonders überraschend ist es, daß mit Dispersionen, die durch Elektrolytzusätze bewußt nahe an ihre Koagulationsgrenze gebracht werden, ein technisch sicher und gut beherrschbarer Prozess durchgeführt werden kann. Die Stabilitätsfenster lassen sich aber in der Praxis ohne weiteres so setzen, daß einerseits die elektrolythaltigen Dispersionen noch haltbar sind, andererseits aber in Kontakt mit den Koagulationsauslösern spontane Koagulation erfolgt.

Es wurde schon oben ausgeführt, daß mit dem Verfahren der substratinduzierten Koagulation wesentlich dickere Schichten von Festkörper-Partikeln niedergeschlagen werden können, als es mit auf einfacher Adsorption beruhenden Verfahren möglich ist. Damit verbunden ist z.B. die höhere Leitfähigkeit von Beschichtungen aus elektronenleitenden Partikeln. Weiterhin ist das erfindungsgemäße Verfahren der substratinduzierten Koagulation auf allen Oberflächen, insbesondere auf Epoxid-Harzen, Polyimiden und selbst auf PTFE (Teflon) anwendbar.

Zu erwähnen bleibt noch, daß die verfahrensgemäße Koagulation ein in der Regel irreversibler Prozess ist und demzufolge die einmal niedergeschlagenen Feststoff-Partikel ausreichend haften, um einem unmittelbar anschließenden Spülvorgang zu widerstehen. Solche Spülvorgänge sind in der Technik zum Vermeiden von "Verschleppungen" bei der aufeinanderfolgenden Anwendung verschiedener Bäder unumgänglich. Konkurrierende Verfahren zur Belegung von Substraten mit Festkörper-Partikeln durch Tauchen in Dispersionen benötigen dagegen eine zusätzliche thermische Nachbehandlung der Beschichtung, bevor ein Spülvorgang oder eine nachfolgende galvanische Metallabscheidung durchführbar ist (vergl. z.B. US-PS 4 874 477 und US-PS 4 622 108).

Ein weiterer Vorteil der mit der irreversiblen Koagulation verbundenen "Spülfestigkeit" der Schichten aus Feststoff-Partikeln liegt in der Wiederholbarkeit des Vorgangs mit dem Ziel, besonders dicke Schichten aufzubauen. So können z.B. mit den in Beispiel 8 beschriebenen Lösungen (A: Vortauchlösung mit Gelatine, B: Spülwasser, C: Dispersion von kationisch stabilisiertem Ruß mit Zusatz von KCl) durch eine Tauchfolge A-B-C-B-A-B-C-B-A-B-C... u.s.w., sukzessive dicke Rußschichten auf den Substraten aufgebaut werden.

Die Mehrfachbeschichtung ist auch dann möglich, wenn nach der Beschichtung mit der Dispersion (Schritt C) ein Zwischentauchen in Lösungen (I) erfolgt, die das Aufziehen von Isolator-Schichten bewirken. Hierfür geeignet sind höherviskose Polymerdispersionen, wie z.B. konzentrierte Lösungen von Polyacrylaten. Mit derartigen Mehrfachbeschichtungen mit isolierender Zwischenschicht lassen sich Kondensatoren aufbauen.

Ein weiterer Vorteil des erfindungsgemäßen Verfahrens besteht darin, daß es mit Stoffen arbeitet, von denen keinerlei Gefahren für die Gesundheit bzw. für die Umwelt ausgehen. Die polymeren Koagulationsauslöser sind zum großen Teil buchstäblich "eßbar" und werden in der Lebensmitteltechnologie verbreitet eingesetzt (z.B. Gelatine und Carboxymethylcellulose). Auch die Ungefährlichkeit der tensidischen Stabilisatoren für die feinteiligen Feststoffe ist in den meisten Fällen durch langjährigen problemlosen Gebrauch (z.B. in Körperpflegemitteln) erwiesen. Außerdem kommt das Verfahren ohne organische Lösungsmittel aus.

Die erfindungsgemäße Belegung von Trägermaterialien mit Funktionsschichten aus hochdispersen Feststoffen erfolgt im Rahmen dieser Erfindung ausschließlich unter Nutzung des Verfahrens der substratinduzierten Koagulation. Die damit verbundenen Vorzüge gegenüber konventionellen Beschichtungsverfahren erlauben die vorteilhafte Fertigung verschiedener Vorrichtungen, wobei der geringe Anteil an Bindemitteln in der Funktionsschicht ein entscheidender Vorzug ist.

So können z. B. katalytisch aktive Feststoffe, wie z.B. feinverteilte Metalle, Oxide oder Komplexverbindungen, unter weitgehendem Erhalt ihrer katalytischen Aktivität auf Trägermaterialien aufgezogen werden, dabei ist es von besonderem Vorteil, daß es der Prozeß der substratinduzierten Koagulation ermöglicht, praktisch alle Trägermaterialien und alle dispergierbaren Feststoffe einzusetzen. Somit können z.B. Folien, Membran-Materialien, textile Materialien, Schaumstoffe mit katalytisch aktiven Substanzen belegt werden.

Auch dekorative Überzüge mit Feststoff-Partikeln sind nach dem Prinzip der substratinduzierten Koagulation leicht möglich. Zum Schutz der oft nur mäßig abriebfesten mit Feststoff-Partikeln belegten Oberflächen sind dann allerdings transparente Schutzlacke zu empfehlen. Das Tönen von Gläsern ist z. B. durch Belegung mit unstöchiometrischen Wolframoxiden, $WO_x$ oder mit Molybdänsulfid nach dem Prinzip der substratinduzierten Koagulation möglich. Insbesondere die Belegung mit unstöchiometrischen Oxiden, wie $WO_x$ ist dabei von großem Interesse, weil die Farbe bzw. Transparenz solcher Schichten durch ein elektrochemisches Potential verändert werden kann, wodurch sich z.B. elektrisch "ansteuerbare" Lichtschutzgläser aufbauen lassen.

Durch die Auftragung von Sorbentien, wie z.B. Kieselgel ($SiO_2$) das für die Herstellung chromatographischer Dünnschicht-Platten benutzt wird, auf glatte Substrate wie Glas, können solche Dünnschichtplatten mit extrem geringer Schichtdicke erhalten werden. Selbstverständlich kann das Prinzip der substratinduzierten Koagulation auch zur Belegung poröser Materialien großer Oberfläche mit speziellen Sorbentien benutzt werden. Solche Vorrichtungen sind z.B. in den Bereichen der Reinigung und Separation von Gasen und Flüssigkeiten von Bedeutung.

Durch die substratinduzierte Koagulation von leitfähigen hochdispersen Feststoffen lassen sich - im Vergleich zu konventionellen Beschichtungen mit Hilfe von in Lösungen dispergierten Partikeln - recht gut leitende Beschichtungen erzeugen. Das liegt einmal an der relativ großen Menge der abgeschiedenen Partikel, insbesondere wenn von der erläuterten Methode der wiederholten Belegung (mit Zwischentauchen in die Lösung des Koagulationsauslösers) Gebrauch gemacht wird. Günstig wirkt sich aber auch der geringe Anteil der isolierend wirkenden Bindemittel aus.

EP 0 616 558 B1

Die hohe Leitfähigkeit solcher Schichten aus Feststoff-Partikeln ermöglicht auch die Konstruktion extremer elektrotechnischer bzw. elektrochemischer Vorrichtungen. So lassen sich Kondensatoren durch abwechselndes Aufbringen gut leitfähiger und isolierender Schichten erzeugen, wobei die Isolatorschicht z.B. durch Aufsprühen von löslichen oder dispergierbaren Kunststoffen erfolgen kann.

Die Isolatorschicht kann auch die Eigenschaften einer verdickten bzw. "festgelegten" oder polymeren Elektrolytlösung haben. In diesem Fall entstehen durch die abwechselnde Auftragung von Leiter- und Elektrolytschichten Elektrolytkondensatoren bzw. Batterien und Akkumulatoren.

Beispiele

Die folgenden Beispiele sollen das erfindungsgemäße Verfahren erläutern :

Beispiel 1

Ein beliebig geformtes Werkstück, bestehend aus duroplastischem Epoxidharz, wird zunächst in einer wäßrigen Lösung, die 0,5 % Arkopal N 150 (HOECHST) und 5 % Schwefelsäure enthält, 2 min durch Ultraschall gereinigt. Dann wird die Platte nach Spülen (30 s) mit deionisiertem Wasser für die Dauer von 30 s in einer 0,2 %igen wäßrigen Lösung von Mowiol 8-88 (HOECHST) bei 25°C unter horizontaler Warenbewegung vorbehandelt. Die Herstellung der Lösung erfolgt durch Lösen des Feststoffs bei 50°C unter Rühren.

Nach Spülen der Platte mit deionisiertem Wasser (30 s) wird die adsorptive Belegung mit dem Furnaceruß Printex L 6 (DEGUSSA) aus 1 %iger wäßriger Dispersion vorgenommen. Die Rußdispersion wird kationisch mit $3,2 \times 10^{-3}$ mol/l Hexadecyltrimethylammoniumbromid (CTAB) stabilisiert; sie enthält außerdem 0,05 mol/l KCl sowie 0,025 mol/l Ethanol. Zur Herstellung der Dispersion werden zunächst $H_2O$ und CTAB vorgelegt, wobei das Tensid in Form einer Lösung von je 1 Teil CTAB und Ethanol in 98 Teile $H_2O$ zugegeben wird. Darin wird der Ruß eingerührt, anschließend wird 15 min mit Hilfe von Ultraschall dispergiert. Dann wird das KCl in Form einer 1 M Lösung unter Rühren zugegeben, die Dispersion wird auf das Endvolumen aufgefüllt und abschließend nochmals 5 min beschallt. Die Beschichtung erfolgt bei einer Badtemperatur von 30°C unter horizontaler Warenbewegung (Hub: 4 cm, Frequenz: 75 min$^{-1}$); die Beschichtungsdauer beträgt 5 min. Anschließend wird mit deionisiertem Wasser gespült.

Die resultierende dünne Rußschicht erstreckt sich gleichmäßig über das gesamte Werkstück. Der elektrische Widerstand der getrockneten Schicht liegt bei 105 Ω, bezogen auf eine quadratische Fläche. Die Bestimmung des Schichtwiderstands wird an einem Standardobjekt desselben Materials vorgenommen: Dabei handelt es sich um eine 2,8 cm × 1,45 cm große zweiseitig kupferkaschierte Epoxidharz-Leiterplatte (Dicke 0,17 cm), die jeweils 10 Bohrlöcher mit Durchmessern von 1 mm, 0,8 mm und 0,5 mm enthält. Diese Platte wird in derselben Weise gereinigt und mit Kohlenstoff beschichtet wie das Werkstück. Nach dem Trocknen der Platte wird der zwischen den Kupferflächen auftretende Widerstand R gemessen. Der auf eine quadratische Fläche bezogene Widerstand RQu läßt sich daraus berechnen nach:

$$RQu = R \times [2 \times (2,8 + 1,45) + 10\ \pi \times (0,1 + 0,08 + 0,05)]/0,17\ [\Omega]$$
$$= R \times 92,5\ [\Omega]$$

Beispiel 2

Eine glasfaserverstärkte Epoxidharzplatte wird nach der Reinigung analog Beispiel 1 in einer 0,2 %igen Lösung von Carboxymethylcellulose, Na-Salz (FLUKA) bei 25°C für die Dauer von 30 s unter horizontaler Warenbewegung vorbehandelt. Die Herstellung der Lösung erfolgt durch Lösen des Feststoffs unter Rühren bei 70°C. Anschließend wird 30 s mit deionisiertem Wasser gespült.

Wie in Beispiel 1 erfolgt eine Belegung der Oberfläche mit Printex L 6. Die resultierende gleichmäßige Rußschicht ist aber dünner, der analog Beispiel 1 ermittelte Widerstand RQu liegt nach der Trocknung zwischen 105 und 106 Ω.

Beispiel 3

Eine Werkstück aus ABS-Kunststoff wird wie in Beispiel 1 gereinigt und mit deionisiertem Wasser gespült Die Vorbehandlung erfolgt in 0,2 %iger Gelatinelösung (pH 3,2) unter horizontaler Warenbewegung für die Dauer von 30 s. Für einen Badansatz wird die Gelatine (FLUKA) nach 10 min Quellen zunächst in der Wärme gelöst, anschließend wird 5 h bei 10°C stehen gelassen und danach auf 20°C erwärmt.

Nach Spülen mit deionisiertem Wasser wird das Werkstück auf dieselbe Weise wie in Beispiel 1 beschichtet, zum Einsatz kommt hier aber graphitierter Ruß der Fa. SIGRI. Die analog Beispiel 1 hergestellte kationisch stabilisierte Dispersion hat nun folgende Zusammensetzung: 1 % Ruß, $2,5 \times 10^{-3}$ mol/l CTAB, 0,07 mol/l KCl, 0,02 mol/l Ethanol.

Beispiel 4

Eine Platte aus glasfaserverstärktem Epoxidharz wird analog Beispiel 1 gereinigt und mit deionisiertem Wasser gespült. Anschließend wird sie in einer 0,2 %igen Lösung von Polyacrylsäureamid (ALDRICH) unter horizontaler Warenbewegung für eine Zeitdauer von 30 s bei 25°C vorbehandelt. Die Herstellung der Lösung erfolgt durch Auflösen des Feststoffs bei einer Temperatur von 90°C unter Rühren. Danach wird mit deionisiertem Wasser, wiederum für 30 s, gespült.

Die Belegung mit dem Ruß Printex L 6 erfolgt analog Beispiel 1, die Dispersion wird aber anionisch mit Aerosol OT (CYANAMID) stabilisiert. Die 1 %ige Rußdispersion enthält $2,7 \times 10^{-3}$ mol/l Aerosol OT und 0,04 mol/l KCl. Die Herstellung der Dispersion erfolgt analog Beispiel 1, das Tensid wird aber als rein wäßrige Lösung vorgelegt.

Die resultierende Schicht ist sehr dünn und gleichmäßig. Der analog Beispiel 1 bestimmte Widerstand RQu der getrockneten Schicht liegt bei 106 Ω.

Beispiel 5

Eine Platte aus glasfaserverstärktem Epoxidharz wird analog Beispiel 1 gereinigt. Nach Spülen mit deionisiertem Wasser wird die Platte in einer 0,2 %igen Lösung von Natriumalginat (SIGMA) bei 25°C unter horizontaler Warenbewegung für eine Zeitdauer von 30 s vorbehandelt. Anschließend wird mit deionisiertem Wasser, wiederum 30 s gespült.

Es folgt eine Belegung der Oberfläche mit dem Ruß Printex L 6, und zwar aus derselben anionisch stabilisierten Dispersion wie in Beispiel 4. Der analog Beispiel 1 bestimmte Widerstand der gleichmäßig dünnen Schicht ergibt sich nach dem Trocknen zu RQu ≈ 106 Ω.

Beispiel 6

Eine Platte aus glasfaserverstärktem Epoxidharz wird analog Beispiel 1 gereinigt. Nach Spülen mit deionisiertem Wasser wird die Platte in einer 0,01 %igen Lösung des kationischen Flockungsmittels Superfloc C 491 (CYANAMID) bei 25°C unter horizontaler Warenbewegung für eine Zeitdauer von 30 s vorbehandelt. Anschließend wird mit deionisiertem Wasser 30 s gespült.

Es folgt eine Belegung der Oberfläche mit dem Ruß Printex L 6 aus anionisch stabilisierter Dispersion analog Beispiel 4. Der analog Beispiel 1 bestimmte Widerstand der Rußbeschichtung ergibt sich nach dem Trocknen zu RQu ≈ 105 Ω.

Beispiel 7

Ein Werkstück aus Glas wird in einer wäßrigen Lösung, die 0,5 % Arkopal N 150 und 1 % Natronlauge enthält, 5 min bei einer Temperatur von 35°C mit Ultraschall gereinigt. Nach Spülen mit deionisiertem Wasser (30 s) wird für die Dauer von 30 s in eine 0,2 %ige Lösung von Polyvinylpyrrolidon (FLUKA) getaucht. Anschließend wird wiederum 30 s mit deionisiertem Wasser gespült.

Es folgt eine Abscheidung von kolloidalem Graphit aus der im Verhältnis 1:9 verdünnten und danach 15 min mit Ultraschall behandelten Dispersion "Aquadag" (ACHESON). Die Abscheidung erfolgt unter horizontaler Warenbewegung bei einer Temperatur von 25°C für die Dauer von 5 min. Es bildet sich eine äußerst dünne, gleichmäßig die gesamte Oberfläche bedeckende Graphitschicht

Beispiel 8

Eine beidseitig kupferkaschierte Epoxidharz-Leiterplatte, die mit Bohrlöchern (Durchmesser <1mm) versehen ist, wird gereinigt in einer wäßrigen Lösung, die 0,5 % Arkopal N 150 (HOECHST) und 5 % Schwefelsäure enthält. Die Reinigungsdauer beträgt 2 min bei gleichzeitiger Anwendung von Ultraschall. Dann wird die Platte nach Spülen (30 s) mit deionisiertem Wasser in 0,2 %iger Gelatinelösung vorbehandelt, ebenfalls für die Dauer von 30 s. Die Herstellung der Lösung erfolgt analog Beispiel 3, zusätzlich wird jedoch durch Zugabe von Natronlauge der pH-Wert der Gelatinelösung auf pH 7,0 erhöht. Anschließend wird 30 s mit deionisiertem Wasser gespült.

Die Platte wird analog Beispiel 1 in einer kationisch stabilisierten Dispersion mit Printex L 6 beschichtet. Die Dispersion hat jetzt aber folgende Zusammensetzung: 0,25 % Printex L 6, $8 \times 10^{-4}$ mol/l CTAB, 0,05 mol/l KCl sowie $6,3 \times 10^{-3}$ mol/l Ethanol. Im Anschluß an die Beschichtung wird mit deionisiertem Wasser gespült.

Sowohl die Kupferoberfläche als auch die Bohrlochwandungen, deren Oberfläche sich aus Epoxidharz und Glasfasern zusammensetzt, sind vollständig und gleichmäßig mit einer dünnen Rußschicht überzogen. Der analog Beispiel 1 ermittelte Widerstand der getrockneten Schicht ergibt sich zu RQu ≈ 105 Ω.

Beispiel 9

Eine beidseitig kupferkaschierte Epoxidharz-Leiterplatte, die mit Bohrlöchern (Durchmesser <1 mm) versehen ist, wird analog Beispiel 8 gereinigt und in Gelatinelösung (pH 7) vorbehandelt.

Die Platte wird analog Beispiel 4 in anionisch stabilisierter Dispersion mit Printex L 6 beschichtet. Die Dispersion hat jetzt aber folgende Zusammensetzung: 1 % Printex L 6, $2,7 \times 10^{-3}$ mol/l Aerosol OT sowie 0,04 mol/l Ammoniumnitrat.

Wie in Beispiel 8 ist auch hier die gesamte Oberfläche gleichmäßig mit einer dünnen Rußschicht bedeckt. Der elektrische Widerstand RQu der getrockneten Schicht liegt unter 105 $\Omega$.

Beispiel 10

Eine beidseitig kupferkaschierte Epoxidharz-Leiterplatte, die mit Bohrlöchern (Durchmesser <1 mm) versehen ist, wird analog Beispiel 3 gereinigt und in Gelatinelösung (pH 3,2) vorbehandelt. Nach Spülen mit deionisiertem Wasser wird die Platte analog Beispiel 1 durch Abscheidung von Printex L 6 aus kationisch stabilisierter Dispersion beschichtet. Die Dispersion hat jetzt aber folgende Zusammensetzung: 1 % Printex L 6, $3,2 * 10^{-3}$ mol/l CTAB, 0,025 mol/l Ethanol sowie 0,08 mol/l Calciumchlorid.

Auch hier ist die gesamte Oberfläche gleichmäßig mit einer dünnen Rußschicht belegt. Der elektrische Widerstand RQu der getrockneten Schicht liegt bei 105 $\Omega$.

Beispiel 11

Ein Werkstück aus Polyethylen wird analog Beispiel 1 gereinigt und in Mowiol 8-88 vorbehandelt. Nach Spülen mit deionisiertem Wasser wird das Werkstück analog Beispiel 4 in anionisch stabilisierter Dispersion mit Printex L 6 beschichtet. Die Dispersion hat jetzt aber folgende Zusammensetzung: 1 % Printex L 6, $2,7 \times 10^{-3}$ mol/l Aerosol OT sowie 0,04 mol/l Kaliumsulfat.

Nach dem Abspülen der anhaftenden Dispersion ist anhand einer gleichmäßigen Schwärzung der Oberfläche die Belegung mit Ruß erkennbar.

Beispiel 12

Eine Glasplatte wird in einer wässrigen Lösung, die 0,5 % Arkopal N 150 und 0,5 % Natronlauge enthält, 2 min bei einer Temperatur von 30°C mit Ultraschall gereinigt. Die Platte wird analog Beispiel 3 in Gelatinelösung (pH 3,2) vorbehandelt und anschließend mit deionisiertem Wasser gespült.

Es folgt eine Belegung mit kolloidalem Siliciumdioxid ("Aerosil 200", DEGUSSA) durch Abscheidung aus 1 %iger wäßriger Dispersion, die außerdem 0,04 mol/l Kaliumchlorid enthält. Die Herstellung der Dispersion erfolgt mit Hilfe von Ultraschall. Zur Beschichtung wird die vorbehandelte Platte unter horizontaler Bewegung für die Dauer von 2 min in die Dispersion (T = 30°C) getaucht. Nach Spülen mit deionisiertem Wasser wird nochmals in die Gelatinelösung getaucht (30 s), wiederum gespült und dann ein zweites Mal durch Tauchen in die Aerosil-Dispersion beschichtet. Diese Vorgehensweise wird noch dreimal wiederholt. Es resultiert eine mit dem Auge erkennbare geschlossene Belegung der Oberfläche mit Aerosil 200.

Beispiel 13

Eine Glasplatte wird wie in Beispiel 12 gereinigt. Nach Spülen (30 s) mit deionisiertem Wasser wird sie analog Beispiel 8 in Gelatinelösung (pH 7) vorbehandelt und gespült. Dann wird die Platte unter horizontaler Bewegung für die Dauer von 5 min bei 25°C in eine Dispersion von Wolframblau in 0,04 M wäßriger KCl-Lösung getaucht. Nach Spülen mit deionisiertem Wasser ist eine geschlossene Belegung der Glasoberfläche mit Wolframblau zu erkennen.

Zur Herstellung von 300 ml der Dispersion werden 4 g Wolfram(VI)oxid mit Zink und konz. Salzsäure im Überschuß versetzt. Nach ca. 90 min wird die tiefblau-violett gefärbte Suspension filtriert, der Rückstand mit deionisiertem Wasser gewaschen, 12 ml 1 M KCl-Lösung zugesetzt und dann mit deionisiertem Wasser auf das Endvolumen aufgefüllt. Anschließend wird für die Dauer von 15 min mit Ultraschall dispergiert.

Beispiel 14

Eine Glasplatte wird wie in Beispiel 12 gereinigt. Nach Spülen (30 s) mit deionisiertem Wasser wird sie analog Beispiel 8 in Gelatinelösung (pH 7) vorbehandelt und gespült. Danach wird die Platte unter horizontaler Bewegung für eine Zeitdauer von 5 min bei 25°C in eine wäßrige Dispersion von Molybdän(IV)-sulfid (Partikelgröße <1 $\mu$m) getaucht. Die Dispersion hat folgende Zusammensetzung: 1 % Molybdän(IV)sulfid, $1,1 \times 10^{-3}$ mol/l Aerosol, OT, 0,04 mol/l Kaliumchlorid; die Dispergierung erfolgt mit Hilfe von Ultraschall. Nach Spülen mit deionisiertem Wasser wird die Platte in gleicher Weise nochmals in Gelatinelösung vorbehandelt, gespült und ein zweites Mal in die Dispersion getaucht. Dieser Ablauf wird noch einmal wiederholt.

Nach Spülen mit deionisiertem Wasser ist eine geschlossene Belegung der Glasoberfläche mit Molybdän(IV)sulfid zu erkennen.

Beispiel 15

Eine Glasplatte wird in einer wässrigen Lösug, die 0,5% Arkopal N 150 und 0,5% Natronlauge enthält, 2 min bei einer Temperatur von 30°C mit Ultraschall gereinigt. Die Platte wird analog Beispiel 3 in Gelatinelösung (pH 3,2) vorbehandelt und anschließend mit deionisiertem Wasser gespült.

Es folgt eine Belegung mit kolloidalem Siliciumdioxid ("Aerosil 200", DEGUSSA), durch Abscheidung aus 1%iger wässriger Dispersion, die außerdem 0,04 mol/l Kaliumchlorid enthält. Die Herstellung der Dispersion erfolgt mit Hilfe von Ultraschall. Zur Beschichtung wird die vorbehandelte Platte unter horizontaler Bewegung für die Dauer von 2 min in die Dispersion (T = 30°C) getaucht. Nach Spülen mit deionisiertem Wasser wird nochmals in die Gelatinelösung getaucht (30 s), wiederum gespült und dann ein zweites Mal durch Tauchen in die Aerosil-Dispersion beschichtet. Diese Vorgehensweise wird noch dreimal wiederholt. Es resultiert eine mit dem Auge erkennbare geschlossene Belegung der Oberfläche mit Aerosil 200.

Beispiel 16

Eine Glasplatte wird wie in Beispiel 12 gereinigt. Nach Spülen (30 s) mit deionisiertem Wasser wird sie analog Beispiel 8 in Gelatinelösung vorbehandelt und gespült. Dann wird die Platte unter horizontaler Bewegung für die Dauer von 5 min bei 25°C in eine Dispersion von Wolframblau in 0,04 M wässriger KCl-Lösung getaucht. Nach Spülen mit deionisiertem Wasser ist eine geschlossene Belegung der Glasoberfläche mit Wolframblau zu erkennen.

Zur Herstellung von 300 ml der Dispersion werden 4g Wolfram(VI)oxid mit Zink und konz. Salzsäure im Überschuß versetzt. Nach ca. 90 min wird die tiefblau-violett gefärbte Suspension filtriert, der Rückstand mit deionisiertem Wasser gewaschen, 12 ml 1 M KCl-Lösung zugesetzt und dann mit deionisiertem Wasser auf das Endvolumen aufgefüllt.

Anschließend wird für die Dauer von 15 min mit Ultraschall dispergiert.

Beispiel 17

Eine Glasplatte wird wie in Beispiel 12 gereinigt. Nach Spülen (30 s) mit deionisiertem Wasser wird sie analog Beispiel 8 in Gelatinelösung (pH 7) vorbehandelt und gespült. Danach wird die Platte unter horizontaler Bewegung für eine Zeitdauer von 5 min bei 25°C in eine wässrige Dispersion von Molybdän(IV)sulfid (Partikelgröße <1 $\mu$m) getaucht. Die Dispersion hat folgende Zusammensetzung: 1% Molybdän(IV)sulfid, $1,1 \cdot 10^{-3}$ mol/l Aerosol OT, 0,04 mol/l Kaliumchlorid; die Dispergierung erfolgt mit Hilfe von Ultraschall. Nach Spülen mit deionisiertem Wasser wird die Platte in gleicher Weise nochmals in Gelatinelösung vorbehandelt, gespült und ein zweites Mal in die Dispersion getaucht. Dieser Ablauf wird noch einmal wiederholt.

Nach Spülen mit deionisiertem Wasser ist eine geschlossene Belegung der Glasoberfläche mit Molybdänsulfid zu erkennen.

**Patentansprüche**

1. Verwendung von zwei aufeinander abgestimmten wäßrigen Bädern zur Beschichtung von elektrisch nichtleitenden Substratoberflächen durch substratinduzierte Koagulation mit Feststoffpartikeln aus Materialien, ausgewählt aus der Gruppe, bestehend aus Kohlenstoff, $SiO_2$, $MoS_2$, $H_xWO_3$ durch Vorbehandeln des Substrates in einem ersten Bad, welches in polaren Lösungsmitteln gelöste hochmolekulare, in Wasser merklich lösbare zur Adsorption am Substrat und als Koagulationsauslöser geeignete Polyelektrolyte enthält und anschließendes Behandeln in einem zweiten Bad, das eine niedrigviskose Dispersion aus polaren Lösungsmitteln, den Feststoffpartikeln, tensidischen Stabilisatoren in einer die Dispersion knapp stabilisierenden Menge, sowie Elektrolyte enthält, wobei die Elektrolyte die Dispersion destabilisierende Salze sind, die beim Behandeln im zweiten Bad eine irreversible, spülfeste lokale Koagulation der Feststoffpartikel an der Substratoberfläche herbeiführen.

2. Verwendung nach Anspruch 1, dadurch gekennzeichnet, daß zwischen den Behandlungsvorgängen ein Spülvorgang mit Wasser eingeschoben wird.

3. Verwendung nach Anspruch 1 oder 2, dadurch gekennzeichnet, daß die Feststoff-Partikel elektronenleitend sind.

**4.** Verwendung nach Anspruch 3, dadurch gekennzeichnet, daß die Belegung mit elektronenleitenden Feststoff-Partikeln als Vorbereitung für eine galvanische Abscheidung erfolgt.

**5.** Verwendung nach Anspruch 1 oder 2, dadurch gekennzeichnet, daß die in der Vortauchlösung enthaltenen hochmolekularen Stoffe aus der Gruppe der wasserlöslichen Eiweißstoffe und Polysaccharide sowie damit verwandten Naturstoffen gewählt wird.

**6.** Verwendung nach Anspruch 1 oder 2, dadurch gekennzeichnet, daß die in der Vortauchlösung enthaltenen hochmolekularen Stoffe synthetische Polymerisate oder Polykondensate mit dipolarem Charakter der Monomereinheiten sind.

**7.** Verwendung nach Anspruch 1 oder 2, dadurch gekennzeichnet, daß die in der Vortauchlösung enthaltenen hochmolekularen Stoffe Polyelektrolyte mit positiver oder negativer Ladung bzw. sogenannte Betaine sind, die gleichzeitig positive und negative Ladungen tragen.

**8.** Verwendung nach Anspruch 1 oder 2, dadurch gekennzeichnet, daß die in der zweiten Lösung sich befindlichen sedimentationsverhindernden Tenside aus der Gruppe der anionischen, kationischen, ambivalenten oder ungeladenen Tenside gewählt werden.

**9.** Verwendung nach Anspruch 1 oder 2, dadurch gekennzeichnet, daß die in der zweiten Lösung sich befindlichen feinteiligen Feststoff-Partikel aus Graphit oder Ruß bestehen.

**10.** Verwendung nach Anspruch 1 oder 2, dadurch gekennzeichnet, daß die in der zweiten Lösung sich befindlichen Salze für die gezielte Destabilisierung aus der Gruppe der Halogenide, Borate, Carbonate, Nitrate, Phosphate, Sulfate und Chlorate anorganischer einfach, zweifach und dreifach positiv geladener Kationen gewählt sind.

**11.** Verwendung nach Anspruch 1 oder 2, dadurch gekennzeichnet, daß die mit den Feststoff-Partikeln zu belegenden Substrate aus Kunstharzen bzw. Kunstharz-Verbundwerkstoffen bestehen.

**12.** Verwendung nach Anspruch 1, dadurch gekennzeichnet, daß es sich bei den Kunstharzen um Epoxid-Harze, Polyimid-Harze oder Teflon handelt und bei den Kunstharz-Verbundwerkstoffen um mit Glasfasern verstärkte Kunstharze.

**13.** Verwendung nach Anspruch 3 oder 4, dadurch gekennzeichnet, daß die elektronenleitenden Feststoff-Partikel als Vorbereitung zur galvanischen Metallisierung von Bohrlöchern in Leiterplatten oder verwandten elektronischen Komponenten aufgebracht werden.

**14.** Verwendung nach Anspruch 3, 4 oder 11, dadurch gekennzeichnet, daß es sich bei den Leiterplatten um Multilayer-Leiterplatten handelt.

**15.** Verwendung nach Anspruch 1, dadurch gekennzeichnet, daß die Vortauchlösung mit einer bakterizid wirkenden Substanz versetzt ist.

**Claims**

**1.** Use of two aqueous baths, which are adapted to each other, for coating electrically non-conductive substrate surfaces by a substrate-induced coagulation with solid particles of materials, selected from the group consisting of carbon, $SiO_2$, $MoS_2$ and $H_xWO_3$, by pretreating the substrate in a first bath, which contains high-molecular polyelectrolytes, which are dissolved in polar solvents, are substantially soluble in water and are suitable for adsorption on the substrate as coagulation initiators, and by a subsequent treatment in a second bath, which contains a low-viscous dispersion of polar solvents, the solid particles and surfactant stabilisers in a quantity which just stabilises the dispersion, as well as electrolytes, the electrolytes being salts which destabilise the dispersion and, during the treatment in the second bath, cause an irreversible, rinse-resistant local coagulation of the solid particles on the substrate surface.

**2.** Use according to claim 1, characterised in that a rinsing process with water is interposed between the treatment processes.

**3.** Use according to claim 1 or 2, characterised in that the solid particles are electron-conductive.

4. Use according to claim 3, characterised in that electron-conductive solid particles are deposited in preparation for electrodeposition.

5. Use according to claim 1 or 2, characterised in that the high-molecular substances contained in the preliminary immersion solution are selected from the group of water-soluble proteins and polysaccharides as well as natural substances related thereto.

6. Use according to claim 1 or 2, characterised in that the high-molecular substances contained in the preliminary immersion solution are synthetic polymers or polycondensates with the dipolar nature of monomeric units.

7. Use according to claim 1 or 2, characterised in that the high-molecular substances contained in the preliminary immersion solution are polyelectrolytes with a positive or negative charge, or respectively so-called betaines which simultaneously carry positive and negative charges.

8. Use according to claim 1 or 2, characterised in that the sedimentation-preventing surfactants contained in the second solution are selected from the group of anionic, cationic, ambivalent or uncharged surfactants.

9. Use according to claim 1 or 2, characterised in that the finely divided solid particles contained in the second solution are formed from graphite or carbon black.

10. Use according to claim 1 or 2, characterised in that the salts, contained in the second solution and intended for the appropriate destabilisation, are selected from the group of halides, borates, carbonates, nitrates, phosphates, sulphates and chlorates of inorganic, singly-, doubly- and triply-positively charged cations.

11. Use according to claim 1 or 2, characterised in that the substrates which are to be deposited with the solid particles are formed from synthetic resins or respectively synthetic resin composite materials.

12. Use according to claim 1, characterised in that the synthetic resins are epoxy resins, polyimide resins or Teflon, and the synthetic resin composite materials are synthetic resins reinforced with glass fibres.

13. Use according to claim 3 or 4, characterised in that the electron-conductive solid particles are applied in preparation for the electroplating of drill holes in printed circuit boards or related electronic components.

14. Use according to claim 3, 4 or 11, characterised in that the printed circuit boards are multilayer printed circuit boards.

15. Use according to claim 1, characterised in that the preliminary immersion solution is mixed with a bactericidally acting substance.

## Revendications

1. Utilisation de deux bains aqueux adaptés l'un par rapport à l'autre, aux fins du revêtement de surfaces de substrat non conductrices électriquement, par coagulation induite par le substrat avec des particules solides provenant de matériaux choisis parmi le groupe comprenant le carbone, le $SiO_2$, le $MoS_2$ et le $H_xWO_3$, par le prétraitement du substrat dans un premier bain, lequel contient des polyélectrolytes à haut poids moléculaire, dissous dans des solvants polaires, sensiblement solubles dans l'eau aux fins de l'absorption au niveau du substrat, et appropriés en tant que déclencheurs de la coagulation, suivi d'un traitement dans un deuxième bain, lequel contient une dispersion de faible viscosité constituée de solvants polaires, de particules solides, de stabilisateurs tensioactifs dans une proportion stabilisant tout juste la dispersion, ainsi que d'électrolytes, les électrolytes étant des sels déstabilisant la dispersion, qui entraînent lors du traitement dans le second bain, une coagulation locale, non lessivable et irréversible des particules solides à la surface du substrat.

2. Utilisation selon la revendication 1, caractérisée en ce que l'on intercale entre les étapes du traitement une étape de nettoyage avec de l'eau.

3. Utilisation selon la revendication 1 ou 2, caractérisée en ce que les particules solides sont conductrices par électrons.

4. Utilisation selon la revendication 3, caractérisée en ce que le revêtement à l'aide de particules solides conductrices d'électrons est effectué en tant que préparation pour une déposition galvanique.

5. Utilisation selon la revendication 1 ou 2, caractérisée en ce que les substances à haut poids moléculaire contenues dans la solution du bain de prétraitement sont choisies parmi le groupe des protéines et polysaccharides solubles dans l'eau ainsi que des substances naturelles de la même famille.

6. Utilisation selon la revendication 1 ou 2, caractérisée en ce que les substances à haut poids moléculaire contenues dans la solution du bain de prétraitement sont des polymérisats ou des polycondensats synthétiques présentant un caractère dipolaire des unités de monomères.

7. Utilisation selon la revendication 1 ou 2, caractérisée en ce que les substances à haut poids moléculaire contenues dans la solution du bain de prétraitement sont des polyélectrolytes à charge positive ou négative ou bien ce que l'on appelle des bétaïnes, qui portent en même temps des charges positives et négatives.

8. Utilisation selon la revendication 1 ou 2, caractérisée en ce que les agents tensioactifs empêchant la sédimentation qui se trouvent dans la deuxième solution, sont choisis dans le groupe des tensioactifs anioniques, cationiques, ambivalents ou non chargés.

9. Utilisation selon la revendication 1 ou 2, caractérisée en ce que les particules solides fines se trouvant dans la deuxième solution sont constituées de graphite ou de suie.

10. Utilisation selon la revendication 1 ou 2, caractérisée en ce que les sels destinés à la déstabilisation appropriée, qui se trouvent dans la deuxième solution, sont choisis dans le groupe des halogénures, borates, carbonates, nitrates, phosphates, sulfates et chlorates de cations inorganiques avec une, deux ou trois charges positives.

11. Utilisation selon la revendication 1 ou 2, caractérisée en ce que les substrats devant être revêtus avec les particules solides sont constitués de résines synthétiques ou de matériaux composites à base de résine synthétique.

12. Utilisation selon la revendication 1, caractérisée en ce que les résines synthétiques dont il est question sont des résines époxy, polyimides ou du Téflon, et que les composites à base de résine synthétique sont des résines synthétiques renforcées par des fibres de verre.

13. Utilisation selon la revendication 3 ou 4, caractérisée en ce que les particules solides conductrices d'électrons sont déposées en tant que préparation à la métallisation galvanique d'alésages dans des plaquettes de circuits imprimés ou dans des composants électroniques du même type.

14. Utilisation selon la revendication 3, 4 ou 11, caractérisée en ce que les plaquettes de circuits imprimés dont il est question sont des plaquettes de circuits imprimés multicouches.

15. Utilisation selon la revendication 1, caractérisée en ce que la solution du bain de prétraitement est mélangée à une substance ayant une action bactéricide.